# EUROPÄISCHE PATENTANMELDUNG

(11) **EP 3 001 525 A1**
(43) Veröffentlichungstag der Anmeldung: **30.03.2016**
(21) Anmeldenummer: 15185176.3
(22) Anmeldetag: 15.09.2015
(51) Int. Cl.: H02H 9/04, H01L 23/051

(54) **KURZSCHLUSSSCHALTER MIT HALBLEITERSCHALTER UND ANORDNUNG ZUM KURZSCHLIESSEN EINER DREIPHASIGEN WECHSELSPANNUNG**

(30) Priorität: 24.09.2014 DE 202014104564 U
(71) Anmelder: Raycap, S.A., 15124 Maroussi Athens (GR)
(72) Erfinder: FALK, Andreas, 34131 Kassel (DE); KRUG, Alexander, 34125 Kassel (DE); ROTHENBURGER, Max, 34225 Baunatal (DE); SCHULZE, Gerold, 34121 Kassel (DE)
(74) Vertreter: Reichl, Philipp

(57) **Zusammenfassung**

Die Erfindung betrifft einen Kurzschlussschalter (1) mit einem zum Kurzschließen einer zwischen zwei Leitern (21, 22) anliegenden Spannung (20) ansteuerbaren Halbleiterschalter. Der Halbleiterschalter ist ein Thyristor (2) vom Press Pack-Typ mit flächigen Kontaktelektroden (3 und 4) auf einander gegenüberliegenden Kontaktseiten. Der Thyristor (2) ist in einer mechanischen Press Pack-Struktur (6) angeordnet, in der sich eine Anschlusselektrode (9) zum Anschluss der einen Kontaktelektrode (4) an den einen Leiter (22) über eine Federanordnung (11) elastisch an einer Anschlusselektrode (8) zum Anschluss der anderen Kontaktelektrode (3) an den anderen Leiter (22) abstützt. Die Press Pack-Struktur (6) bildet eine den Thyristor (2) umhüllende Schutzhülle (23) aus.

## Beschreibung

### TECHNISCHES GEBIET DER ERFINDUNG

Die Erfindung bezieht sich auf einen Kurzschlussschalter mit einem zum Kurzschließen einer zwischen zwei Leitern anliegenden Spannung ansteuerbaren Halbleiterschalter, auf die Verwendung eines Thyristors vom Press Pack-Typ und auf eine Anordnung zum Kurzschließen einer zwischen drei Leitern anliegenden dreiphasigen Wechselspannung mit ansteuerbaren Halbleiterschalter aufweisenden Kurzschlussschaltern.

### STAND DER TECHNIK

In der DE 10 2013 103 753 A1 wird beschrieben, dass es zum Schutz eines Wechselrichters einer Photovoltaikanlage im Fehlerfall sinnvoll ist, sowohl die eingangsseitig anliegende Gleichspannung eines Photovoltaikgenerators als auch die ausgangsseitig anliegende, insbesondere dreiphasige Wechselspannung eines Wechselstromnetzes auch zusätzlich zum Trennen des Wechselrichters von dem Photovoltaikgenerator und dem Wechselstromnetz kurzzuschließen, weil durch das Kurzschließen ein möglicherweise gefährlicher Stromfluss in den Wechselrichter schneller verhindert werden kann als durch das Trennen. Zum Kurzschließen der Gleichspannung des Photovoltaikgenerators und der Wechselspannung des Wechselstromnetzes schlägt die DE 10 2013 103 753 A1 DC- und AC-Kurzschlussschalter mit jeweils mindestens einem Halbleiterschalter vor. Nähere Informationen zu den Kurzschlussschaltern enthält dieses Dokument jedoch nicht.

Insbesondere über die AC-Kurzschlussschalter gemäß der DE 10 2013 103 753 A1 fließende Ströme erreichen schnell eine Größenordnung von 100 kA und mehr, weil diese Ströme ungedämpft sein müssen, um den Zweck des Schutzes des Wechselrichters zu erreichen. Halbleiterschalter, die für so große Ströme ausgelegt sind, sind nicht kommerziell verfügbar. Wenn man einen Kurzschlussschalter auf Basis von Halbleiterschaltern für derart große Ströme dimensionieren würde, würde er sehr kostspielig werden.

Handelsüblich sind AC-Kurzschlussschalter mit einem durch eine Sprengladung bewegten Schaltkontakt, hierzu zählt das Produkt Arcon der Firma Eaton, oder mit einem durch eine vorgespannte Feder bewegten Schaltkontakt, hierzu zählt das Produkt DehnArc der Firma Dehn. Diese Kurzschlussschalter sind zum einen sehr kostspielig und zum anderen verglichen mit einem Halbleiterschalter relativ langsam.

Für Leistungsanwendungen ist es bekannt, Halbleiterbauteile vom so genannten Press Pack-Typ zu verwenden. Diese Halbleiterbauteile weisen auf voneinander abgekehrten Kontaktseiten parallel zu einander ausgerichtete flächige Kontaktelektroden auf. Bei der Montage der Halbleiterbauteile vom Press Pack-Typ werden diese Kontaktelektroden über flächige Anschlusselektroden kontaktiert, die mit hoher Steifigkeit elastisch gegeneinander beaufschlagt sind. Auf diese Weise wird die flächige Kontaktierung des Halbleiterbauteils auch unter hoher thermischer Belastung durch hohe fließende Leistungsströme sichergestellt. Zu den Halbleiterbauteilen, die speziell als Press Pack-Typ verfügbar sind, zählen u. a. IGBTs und Thyristoren.

Zur Ausbildung von Überspannungsableitern, die große Ströme zu tragen vermögen, ist es bekannt, eine druckkontaktierbare Varistorscheiben jeweils in einer Struktur anzuordnen, in der sich eine Anschlusselektrode zum Anschluss einer Kontaktelektrode der Varistorscheibe über eine Federanordnung elastisch an einer anderen Anschlusselektrode zum Anschluss der anderen Kontaktelektrode der Varistorscheibe abstützt und bei der die Struktur eine die Varistorscheibe umhüllende Schutzhülle aufweist. Die Schutzhülle verhindert, dass im Falle einer Zerstörung der Varistorscheibe durch bei der Ableitung großer Überspannungen fließende hohe Ströme von der Varistorscheibe emittierte Partikel oder Gase austreten und Schäden herbeiführen können.

Die EP 1 116 246 B1 beschreibt einen Überspannungsableiter mit einer druckkontaktierbaren Varistorscheibe in einer Struktur, bei der die Schutzhülle einen die Anschlusselektrode ausbildenden und die Varistorscheibe aufnehmenden Becher und einen die andere Anschlusselektrode ausbildenden, in den Becher eingeführten und die andere Anschlusselektrode ausbildenden Kolben aufweist. Dabei stützt sich der Kolben über Tellerfedern und eine Isolierung an einem an dem Becher festliegenden Innenflansch ab. Der Becher und der Kolben sind aus Aluminium ausgebildet.

Aus der DE 198 39 422 A1 ist eine druckkontaktierbare Varistorscheibe in einer Struktur bekannt, bei der die Schutzhülle aus einem dehnbaren Gewebe ausgebildet ist.

### AUFGABE DER ERFINDUNG

Der Erfindung liegt die Aufgabe zugrunde, einen Kurzschlussschalter mit einem zum Kurzschließen einer zwischen zwei Leitern anliegenden Spannung ansteuerbaren Halbleiterschalter aufzuzeigen, der kostengünstig und im Wesentlichen unter Verwendung handelsüblicher Komponenten bereitstellbar ist. Weiterhin soll eine ungewöhnliche Verwendung eines Thyristors vom Press Pack-Typ aufgezeichnet werden. Letztlich soll eine konkrete kostengünstige Anordnung zum Kurzschließen einer dreiphasigen Wechselspannung beschrieben werden.

### LÖSUNG

Die Aufgabe der Erfindung wird durch einen Kurzschlussschalter mit den Merkmalen des unabhängigen Schutzanspruchs 1 und eine Anordnung zum Kurzschließen einer zwischen drei Leitern anliegenden dreiphasigen Wechselspannung mit dem Merkmal des Schutzanspruchs 7 gelöst. Bevorzugte Ausführungsformen des Kurzschlussschalters, der Verwendung und der Anordnung sind den abhängigen Schutzansprüchen zu entnehmen.

### BESCHREIBUNG DER ERFINDUNG

Bei einem erfindungsgemäßen Kurzschlussschalter mit einem zum Kurzschließen einer zwischen zwei Leitern anliegenden Spannung ansteuerbaren Halbleiterschalter ist der Halbleiterschalter ein Thyristor vom Press Pack-Typ mit flächigen Kontaktelektroden auf einander gegenüberliegenden Kontaktseiten, und der Thyristor ist in einer mechanischen Press Pack-Struktur angeordnet, in der sich eine Anschlusselektrode zum Anschluss der einen Kontaktelektrode an den einen Leiter über eine Federanordnung elastisch an einer Anschlusselektrode zum Anschluss der anderen Kontaktelektrode an den anderen Leiter abstützt. Diese Abstützung ist der Press Pack-Struktur inhärent. Das heißt, sie führt vollständig über Teile der Press Pack-Struktur und ist entsprechend nicht erst in montiertem Zustand der Press Pack-Struktur vorhanden. Es versteht sich, dass auch der Steuerkontakt des Thyristors kontaktiert werden muss. Hierzu ist aber nicht die Aufbringung einer größeren Kontaktkraft wie gegenüber seinen Kontaktelektroden erforderlich. Dies liegt daran, dass der Zündstrom eines Thyristors so klein ist, dass keine große Kontaktfläche vonnöten ist, und dass ein Thyristor nach dem Zünden leitfähig bleibt und daher das Ansteuersignal nicht dauerhaft anliegen muss.

Zwar sind kostengünstig auch keine Thyristoren verfügbar, die für Ströme im Bereich von 100 kA und darüber hinausgehend ausgelegt wären. Bei dem erfindungsgemäßen Kurzschlussschalter wird jedoch die Tatsache ausgenutzt, dass ein durch einen zu großen Strom überlasteter Thyristor zwischen seinen Kontaktelektroden leitfähig bleibt. Aufgrund der Verwendung eines Thyristors vom Press Pack-Typ wird diese Leitfähigkeit des bereits irreversibel zerstörten Thyristors nutzbar, indem die Kontaktierung seiner Kontaktelektroden auch über seine Zerstörung hinweg sichergestellt wird. Anders gesagt wird bei dem erfindungsgemäßen Kurzschlussschalter gar nicht versucht, den Thyristor für den zu schaltenden Kurzschlussstrom auszulegen. Vielmehr ist sein Thyristor so dimensioniert, dass er durch eine beim Kurzschließen der zwischen den beiden Leitern anliegenden Spannung fließenden Kurzschlussstrom als ansteuerbarer Halbleiterschalter zerstört wird. Dies ist ohne Weiteres hinzunehmen, da auch bekannte Kurzschlussschalter für große Kurzschlussströme nur zur einmaligen Verwendung vorgesehen sind.

Anders als beispielsweise Kurzschlussschalter mit Sprengladung zur Betätigung des Schaltkontakts kann aber die Funktion eines erfindungsgemäßen Kurzschlussschalters durch Zünden des Thyristors überprüft werden, sofern dabei der zwischen den beiden Leitern fließende Strom so klein gehalten wird, dass der Thyristor nicht irreversibel überlastet wird.

Die erfindungsgemäße Verwendung eines Thyristors vom Press Pack-Typ ist die zum Kurzschließen einer zwischen zwei Leitern anliegenden Spannung, wobei der Thyristor so dimensioniert ist, dass er durch einen beim Kurzschließen der zwischen den beiden Leitern anliegenden Spannung fließenden Kurzschlussstrom als ansteuerbarer Halbleiterschalter zerstört wird. Der Thyristor leitet dennoch weiterhin den Kurzschlussstrom und bleibt dabei aufgrund seiner Ausbildung vom Press Pack-Typ auch weiterhin kontaktiert, d. h. an die beiden Leiter angeschlossen.

Dies gilt insbesondere, wenn der Thyristor vom Press Pack-Typ mit flächigen Kontaktelektroden auf einander gegenüberliegenden Kontaktseiten in einer mechanischen Press Pack-Struktur angeordnet ist, in der sich eine Anschlusselektrode, die die eine Kontaktelektrode an den einen Leiter anschließt, über eine Federanordnung elastisch an einer Anschlusselektrode abstützt, die die andere Kontaktelektrode an den anderen Leiter anschließt. Dadurch ist die Kontaktkraft auf die Kontaktelektrode nicht von der weiteren Montageumgebung des Thyristors vom Press Pack-Typ abhängig.

Konkret kann der Kurzschlussstrom, der über den erfindungsgemäßen Kurzschlussschalter bzw. bei der erfindungsgemäßen Verwendung eines Thyristors vom Press Pack-Typ fließt, mindestens 50 mal höher sein als ein Nennstrom, zu dessen Schalten der Thyristor ausgelegt ist. Der Kurzschlussstrom kann auch mindestens 100 mal höher sein oder sogar mindestens 150 mal höher sein als der Nennstrom. Erfolgreich wurde die Erfindung bei einem Kurzschlussstrom erprobt, der 300 mal höher war als der Nennstrom. Auch darüber hinausgehende Kurzschlussströme sollten möglich sein, wenn der jeweilige Thyristor einen ausreichend großen zulässigen I²t-Wert aufweist. Dieser Wert sollte in der Einheit kA²s mindestens so groß sein wie und vorzugsweise größer sein als, mehr bevorzugt mindestens doppelt so groß sein wie der Nennstrom des Thyristors in der Einheit A.

Bei der Erfindung weist die Press Pack-Struktur vorzugsweise zusätzlich eine den Thyristor umhüllende Schutzhülle auf, um bei seiner planmäßigen Überlastung und Zerstörung möglicherweise freigesetzte Partikel und auch Gase zumindest soweit zurückzuhalten, dass sie keine Schäden an anderen Einrichtungen hervorrufen.

Konkret kann die Schutzhülle einen die eine Anschlusselektrode ausbildenden und den Thyristor aufnehmenden Becher und einen in den Becher eingeführten und die andere Anschlusselektrode ausbildenden Kolben aufweisen, wobei sich der Kolben über die Federanordnung und eine Isolierung an einem an dem Becher festliegenden Innenflansch abstützt. Eine Kontaktierung des Steuerkontakts des Thyristors kann dabei durch eine Querbohrung in den Becher hindurch erfolgen, ohne dass dadurch die Funktion der Schutzhülle beeinträchtigt wird. Bis auf die zusätzliche Kontaktierung des Steuerkontakts des Thyristors kann die Press Pack-Struktur mit ihrer Schutzhülle dem Stand der Technik für Varistoren vom Press Pack-Typ entsprechen.

Bei einer erfindungsgemäßen Anordnung zum Kurzschließen einer zwischen drei Leitern anliegenden dreiphasigen Wechselspannung mit ansteuerbaren Halbleiterschalter aufweisenden Kurzschlussschaltern sind die Kurzschlussschalter jeweils erfindungsgemäße Kurzschlussschalter mit Thyristoren vom Press Pack-Typ.

Konkret können drei der Kurzschlussschalter jeweils zwischen zwei der drei Leiter geschaltet sein, wobei Leitungsrichtungen der angesteuerten Thyristoren so ausgerichtet sind, dass von den zwei mit jedem Leiter verbundene angesteuerten Thyristoren einer zu dem Leiter hin und einer von dem Leiter weg leitet. Jede zwischen den Leitern anliegende Spannung wird so durch die angesteuerten, d. h. gezündeten Thyristoren kurzgeschlossen. Grundsätzlich können auch zwei Paare von antiparallel ausgerichteten Thyristoren zwischen einem der Leiter und den beiden anderen Leitern vorgesehen sein.

Bezüglich des mechanischen Aufbaus können die Press Pack-Strukturen der erfindungsgemäßen Kurzschlussschalter zwischen parallel zueinander ausgerichteten Schenkeln von an die Leiter ausbildenden und parallel zueinander verlaufenden Stromschienen befestigten, elektrisch leitfähigen Winkelstücken montiert sein. Dabei können zwei der Press Pack-Strukturen direkt zwischen parallelen Schenkeln von direkt an den drei Leitern befestigten Winkelstücken angeordnet sein, während die dritte Press Pack-Struktur direkt zwischen parallelen Schenkeln eines der direkt an einem der Leiter befestigten Winkelstücke und eines an einem anderen der direkt an einem der Leiter befestigten Winkelstücke befestigten, elektrisch leitfähigen Zwischenwinkelstück angeordnet ist.

Eine besonders kompakte Anordnung ergibt sich bei diesem mechanischen Aufbau dann, wenn die zwei der Press Pack-Strukturen auf einer Achse liegen, wobei das zwischen ihnen liegende Winkelstück U-förmig ist, während die dritte Press Pack-Struktur auf einer dazu parallelen Achse liegt. In diesem Fall kann das Zwischenwinkelstück, das direkt an der dritten Press Pack-Struktur anliegt, durch ein nicht elektrisch leitfähiges Hilfswinkelstück an dem U-förmigen Winkelstück abgestützt sein.

Vorteilhafte Weiterbildungen der Erfindung ergeben sich aus den Schutzansprüchen, der Beschreibung und den Zeichnungen. Die in der Beschreibung genannten Vorteile von Merkmalen und von Kombinationen mehrerer Merkmale sind lediglich beispielhaft und können alternativ ) oder kumulativ zur Wirkung kommen, ohne dass die Vorteile zwingend von erfindungsgemäßen Ausführungsformen erzielt werden müssen. Ohne dass hierdurch der Gegenstand der beigefügten Schutzansprüche verändert wird, gilt hinsichtlich des Offenbarungsgehalts der ursprünglichen Anmeldungsunterlagen und des Gebrauchsmusters Folgendes: weitere Merkmale sind den Zeichnungen - insbesondere den dargestellten Geometrien und den relativen Abmessungen mehrerer Bauteile zueinander sowie deren relativer Anordnung und Wirkverbindung - zu entnehmen. Die Kombination von Merkmalen unterschiedlicher Ausführungsformen der Erfindung oder von Merkmalen unterschiedlicher Schutzansprüche ist ebenfalls abweichend von den gewählten Rückbeziehungen der Schutzansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Schutzansprüche kombiniert werden. Ebenso können in den Schutzansprüchen aufgeführte Merkmale für weitere Ausführungsformen der Erfindung entfallen.

Die in den Schutzansprüchen und der Beschreibung genannten Merkmale sind bezüglich ihrer Anzahl so zu verstehen, dass genau diese Anzahl oder eine größere Anzahl als die genannte Anzahl vorhanden ist, ohne dass es einer expliziten Verwendung des Adverbs "mindestens" bedarf. Wenn also beispielsweise von einem Element die Rede ist, ist dies so zu verstehen, dass genau ein Element, zwei Elemente oder mehr Elemente vorhanden sind. Diese Merkmale können durch andere Merkmale ergänzt werden oder die einzigen Merkmale sein, aus denen das jeweilige Erzeugnis besteht.

Die in den Schutzansprüchen enthaltenen Bezugszeichen stellen keine Beschränkung des Umfangs der durch die Schutzansprüche geschützten Gegenstände dar. Sie dienen lediglich dem Zweck, die Schutzansprüche anhand möglicher Ausführungsformen der Erfindung leichter verständlich zu machen.

### KURZBESCHREIBUNG DER FIGUREN

Die Erfindung wird im Folgenden anhand von konkreten Ausführungsbeispielen unter Bezugnahme auf die beigefügten Zeichnungen näher erläutert und beschrieben.
- **Fig. 1**: ist ein Längsschnitt durch einen erfindungsgemäßen Kurzschlussschalter, wobei schematisch auch seine Verwendung angedeutet ist.
- **Fig. 2**: zeigt eine erfindungsgemäße Anordnung zum Kurzschließen einer dreiphasigen Wechselspannung in einer Ansicht von oben.
- **Fig. 3**: zeigt eine Seitenansicht der Anordnung gemäß Fig. 2 aus einer ersten Richtung.
- **Fig. 4**: zeigt eine Seitenansicht der Anordnung gemäß den Fig. 2 und 3 aus einer zweiten Richtung.
- **Fig. 5**: ist ein Ersatzschaltbild der Anordnung gemäß den Fig. 1 bis 4.
- **Fig. 6**: ist ein Ersatzschaltbild für eine alternative erfindungsgemäße Anordnung.

### FIGURENBESCHREIBUNG

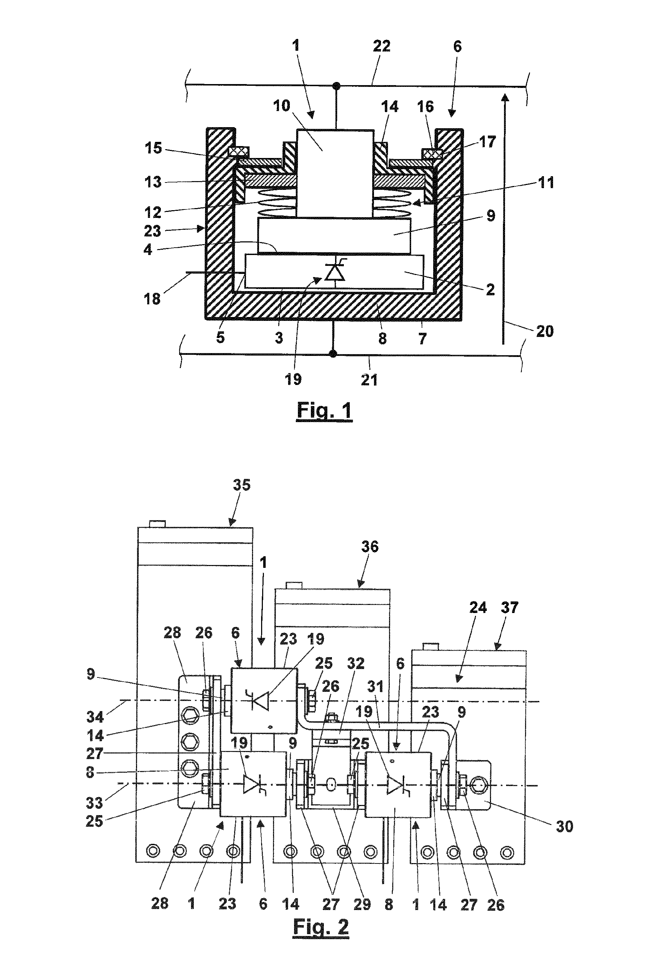

Der in Fig. 1 dargestellte Kurzschlussschalter 1 umfasst einen Halbleiterschalter in Form eines Thyristors 2. Der Thyristor 2 ist vom Press Pack-Typ mit großflächigen Kontaktelektroden 3 und 4 auf einander gegenüberliegenden Kontaktseiten und einem weiteren Kontaktanschluss 5 zum Ansteuern, d. h. Zünden des Thyristors 2. Der Thyristor 2 vom Press Pack-Typ ist in einer Press Pack-Struktur 6 angeordnet. Die Press Pack-Struktur 6 umfasst einen Becher 7, der eine Anschlusselektrode 8 ausbildet, die an der einen Kontaktelektrode 3 des Thyristors 2 anliegt. Die andere Kontaktelektrode 4 wird von einem eine andere Anschlusselektrode 9 ausbildenden Stempel oder Kolben 10 kontaktiert. Der Kolben 10 ist hier ebenso wie der Becher 7 aus Aluminium ausgebildet. Er kann grundsätzlich auch aus einem anderen gut elektrisch leitfähigen Material ausgebildet sein. Um die Kontaktelektroden 3 und 4 zwischen den Anschlusselektroden 8 und 9 mit einer Kontaktkraft zu beaufschlagen, stützt sich der Kolben 10 über eine Federanordnung 11 elastisch an dem Becher 7 ab. Die Federanordnung 11 umfasst Tellerfedern 12, die sich unmittelbar an einer Metallplatte 13 abstützen, welche rückwärtig an einer Isolierung 14 anliegt. Die Isolierung 14 wiederum stützt sich an einer Metallplatte 15 ab, die sich über einen Sprengring 16 an den Becher 7 abstützt, wobei der Sprengring 16 in eine Nut 17 im Umfang des Bechers 7 eingreift. Die elastische Abstützung des Kolbens 10 gegenüber dem Becher 7 und damit der Anschlusselektrode 9 gegenüber der Anschlusselektrode 8 erfolgt in der Press Pack-Struktur 6, d. h. unabhängig von der Montage der Press Pack-Struktur 6 bei der Verwendung des Kurzschlussschalters 1. Durch den Becher 7 führt eine Anschlussleitung 18 von einer hier nicht dargestellten Steuerung zu dem Steuerkontakt des Thyristors 2. Durch Ansteuern, d. h. Zünden des Thyristors über die Steuerleitung 18 wird dieser in der durch das Schaltsymbol 19 für einen Thyristor angedeuteten Richtung leitfähig und kann damit eine Spannung 20, die zwischen zwei Leitungen 21 und 22, an welche die Anschlusselektroden 8 und 9 angeschlossen sind, anliegt, kurzschließen. Der dann fließende Kurzschlussstrom kann den Nennstrom des Thyristors 2 um mehr als das 100fache übersteigen, ohne dass der Kurzschlussschalter 1 seine Funktion einbüßt, weil auch der durch einen so großen Kurzschlussstrom irreversibel zerstörte Thyristor 2 leitfähig bleibt und diese Leitfähigkeit bei dem Kurzschlussschalter 1 durch die Ausbildung des Thyristors 2 vom Press Pack-Typ und seine Anordnung in der Press Pack-Struktur 6 weiter genutzt werden kann. Die von der Press Pack-Struktur 6 mit dem Becher 7 und den daran festgelegten Teilen ausgebildete Schutzhülle 23 um den Thyristor 2 stellt sicher, dass aus dem Thyristor 2 bei dessen Überlastung austretende Partikel und Gase zurückgehalten werden und keine Schäden in der Umgebung des Kurzschlussschalters 1 anrichten können.

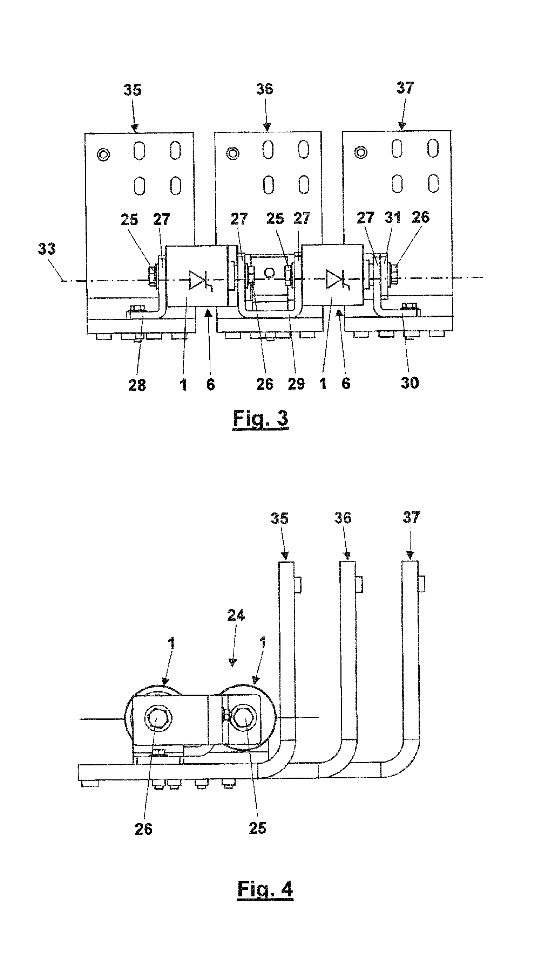

Die **Fig. 2 bis 4** zeigen eine Anordnung 24 mit drei Schutzschaltern 1 gemäß Fig. 1 aus unterschiedlichen Blickrichtungen. Die Press Pack-Strukturen 6 sind mit Befestigungsschrauben 25 und 26 an parallel zueinander verlaufende Schenkel 27 von Winkelstücken 28 bis 31 montiert. Dabei kontaktiert jede Schraube 25 eine Anschlusselektrode 8 und jede Schraube 26 eine Anschlusselektrode 9. Die Winkelstücke 27 bis 30 sind zum direkten Verschrauben mit Stromschienen 35, 36 und 37 vorgesehen, zwischen denen die dreiphasige Wechselspannung anliegt, die mit den Kurzschlussschaltern 1 kurzgeschlossen werden soll. Das Winkelstück 31 ist ein Zwischenwinkelstück, das an dem Winkelstück 30 festgelegt ist und über ein im Gegensatz zu den Winkelstücken 28 bis 31 nicht elektrisch leitfähiges Hilfswinkelstück 32 an dem U-förmig ausgebildeten Winkelstück 29 abgestützt ist. Die unmittelbar zwischen den Winkelstücken 28, 29 und 30 angeordneten Press Pack-Strukturen 6 liegen auf einer Achse 33, die dritte Press Pack-Struktur 6, die an dem Zwischenwinkelstück 31 anliegt, auf einer parallelen Achse 34. So wird eine insgesamt kompakte räumliche Anordnung der Kurzschlussschalter 1 erreicht.

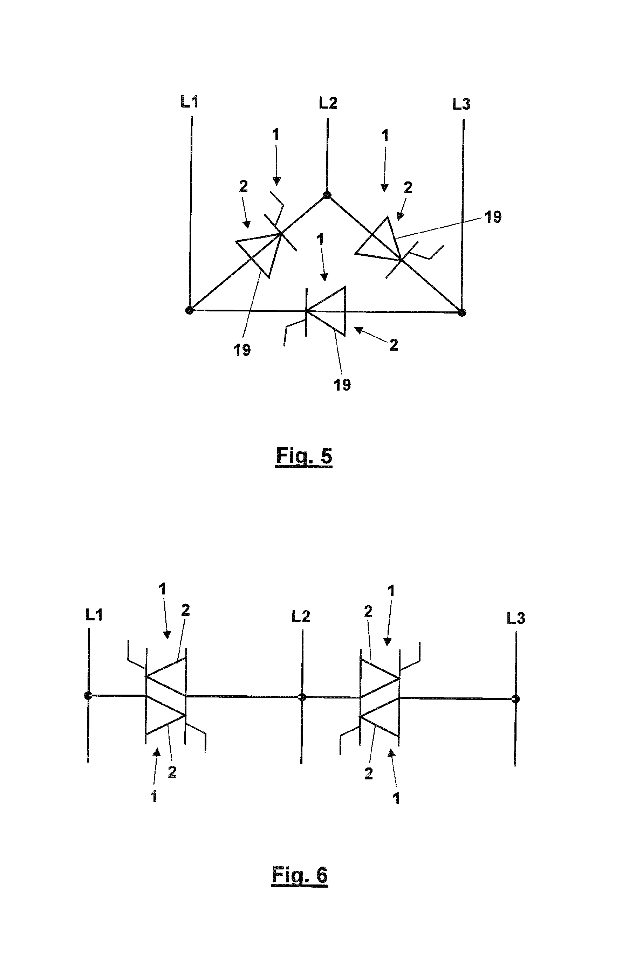

**Fig. 5** zeigt ein elektrisches Ersatzschaltbild der Anordnung 24 gemäß den Fig. 2 bis 4 zwischen drei Leitern L1 bis L3. Jeder der Leiter L1 bis L3 ist über jeweils einen der Thyristoren 2 mit jedem der beiden anderen Leiter verbunden. Dabei verlaufen die Leitungsrichtungen der gezündeten Thyristoren 2 jeweils einmal zu dem jeweiligen Leiter hin und einmal von dem jeweiligen Leiter weg. Jede zwischen den Leitern L1 bis L3 anliegende Spannung wird so, wenn alle Thyristoren 2 gezündet sind, über die Thyristoren 2 kurzgeschlossen und zwar bei der erfindungsgemäßen Ausbildung der Kurzschlussschalter 1 auch dann noch, wenn die Thyristoren 2 selbst bereits irreversibel zerstört sind.

**Fig. 6** zeigt ein Ersatzschaltbild für eine alternative Anordnung von vier Kurzschlussschaltern 1 mit jeweils einem Thyristor 2 zum Kurzschließen einer dreiphasigen Wechselspannung zwischen drei Leitern L1 bis L 3. Hier sind jeweils zwei der Thyristoren 2 als antiparalleles Paar zwischen zwei der Leiter L1 bis L3 angeordnet. Dabei können diese beiden antiparallel ausgerichteten Thyristoren zu einem bidirektionalen Kurzschlussschalter zusammengefasst sein. Sie müssen in diesen dann aber einzeln so angeordnet sein, dass der unidirektionale Kurzschlussschalter in ihrer jeweiligen Leitungsrichtung leitfähig bleibt. Dazu müssen sie einzeln elastisch beaufschlagt sein.

### BEZUGSZEICHENLISTE

- 1: Kurzschlussschalter
- 2: Thyristor
- 3: Kontaktelektrode
- 4: Kontaktelektrode
- 5: Steuerkontakt
- 6: Press Pack-Struktur
- 7: Becher
- 8: Anschlusselektrode
- 9: Anschlusselektrode
- 10: Kolben
- 11: Federanordnung
- 12: Tellerfeder
- 13: Metallplatte
- 14: Isolierung
- 15: Metallplatte
- 16: Sprengring
- 17: Nut
- 18: Steuerleitung
- 19: Symbol
- 20: Spannung
- 21: Leiter
- 22: Leiter
- 23: Schutzhülle
- 24: Anordnung
- 25: Befestigungsschraube
- 26: Befestigungsschraube
- 27: Schenkel
- 28: Winkelstück
- 29: Winkelstück
- 30: Winkelstück
- 31: Zwischenwinkelstück
- 32: Hilfswinkelstück
- 33: Achse
- 34: Achse
- 35: Stromschiene
- 36: Stromschiene
- 37: Stromschiene
- L1: Leiter
- L2: Leiter
- L3: Leiter

## Patentansprüche

1. Kurzschlussschalter (1) mit einem zum Kurzschließen einer zwischen zwei Leitern (21, 22) anliegenden Spannung (20) ansteuerbaren Halbleiterschalter,
- wobei der Halbleiterschalter ein Thyristor (2) vom Press Pack-Typ mit flächigen Kontaktelektroden (3 und 4) auf einander gegenüberliegenden Kontaktseiten ist und
- wobei der Thyristor (2) in einer mechanischen Press Pack-Struktur (6) angeordnet ist, in der sich eine Anschlusselektrode (9) zum Anschluss der einen Kontaktelektrode (4) an den einen Leiter (22) über eine Federanordnung (11) elastisch an einer Anschlusselektrode (8) zum Anschluss der anderen Kontaktelektrode (3) an den anderen Leiter (22) abstützt, und
- wobei die Press Pack-Struktur (6) eine den Thyristor (2) umhüllende Schutzhülle (23) ausbildet.

2. Kurzschlussschalter (1) nach Anspruch 1, **dadurch gekennzeichnet, dass** der Thyristor (2) so dimensioniert ist, dass er durch einen beim Kurzschließen der zwischen den beiden Leitern (21, 22) anliegenden Spannung (20) fließenden Kurzschlussstrom als ansteuerbarer Halbleiterschalter zerstört wird.

3. Kurzschlussschalter (1) nach Anspruch 2, **dadurch gekennzeichnet, dass** der Kurzschlussstrom mindestens 50 mal höher ist, vorzugsweise mindestens 100 mal höher ist und mehr bevorzugt mindestens 150 mal höher ist als ein Nennstrom zu dessen Schalten der Thyristor (2) ausgelegt ist.

4. Kurzschlussschalter (1) nach Anspruch 3, **dadurch gekennzeichnet, dass** ein zulässiger I²t-Wert des Thyristors (2) in der Einheit kA²s mindestens so groß ist, vorzugsweise mindestens 1,5 mal so groß ist und mehr bevorzugt mindestens 2 mal so groß ist wie der Wert des Nennstroms in der Einheit A.

5. Kurzschlussschalter (1) nach einem der vorangehenden Ansprüche, **dadurch gekennzeichnet, dass** die Schutzhülle (23) einen die andere Anschlusselektrode (8) ausbildenden und den Thyristor (2) aufnehmenden Becher (7) und einen in den Becher (7) eingeführten und die eine Anschlusselektrode (9) ausbildenden Kolben (10) aufweist, wobei sich der Kolben (10) über die Federanordnung (11) und eine Isolierung (14) an dem Becher (7) abstützt.

6. Kurzschlussschalter (1) nach Anspruch 5, **dadurch gekennzeichnet, dass** sich der Kolben (10) über die Federanordnung (11) und die Isolierung (14) an einem an dem Becher (7) festliegenden Innenflansch oder an einem auf den Becher aufgeschraubten und mit einem Ausschnitt versehenen Deckel abstützt.

7. Anordnung (24) zum Kurzschließen einer zwischen drei Leitern (L1, L1, L3) anliegenden dreiphasigen Wechselspannung mit ansteuerbare Halbleiterschalter aufweisenden Kurzschlussschaltern (1), **dadurch gekennzeichnet, dass** die Kurzschlussschalter (1) jeweils nach einem der vorangehenden Ansprüche ausgebildet sind.

8. Anordnung (24) nach Anspruch 7, **dadurch gekennzeichnet, dass** drei der Kurzschlussschalter (1) jeweils zwischen zwei der drei Leitern (L1, L2, L3) geschaltet sind, wobei Leitungsrichtungen der angesteuerten Thyristoren (2) so ausgerichtet sind, dass von den zwei mit jedem Leiter (L1, L2, L3) verbundenen angesteuerten Thyristoren (2) einer zu dem Leiter (L1, L2, L3) hin und einer von dem Leiter (L1, L2, L3) weg leitet.

9. Anordnung (24) nach Anspruch 7 oder 8, **dadurch gekennzeichnet, dass** die Press Pack-Strukturen (6) zwischen parallel zu einander ausgerichteten Schenkeln (27) von an die Leiter (L1, L2, L3) ausbildenden und parallel zueinander verlaufenden Stromschienen (35, 36, 37) befestigten, elektrisch leitfähigen Winkelstücken (28 bis 31) montiert sind.

10. Anordnung (24) nach Anspruch 9, **dadurch gekennzeichnet, dass** zwei der Press Pack-Strukturen (6) direkt zwischen parallelen Schenkeln (27) von direkt an den drei Leitern (L1, L2, 3) befestigten Winkelstücken (28 bis 30) angeordnet sind und dass die dritte Press Pack-Struktur (6) direkt zwischen parallelen Schenkeln eines der direkt an einem der Leiter (L1, L2, L3) befestigten Winkelstücke (28) und eines an einem anderen der direkt an einem der Leiter (L1, L2, L3) befestigten Winkelstücke (30) befestigten, elektrisch leitfähigen Zwischenwinkelstück (31) angeordnet ist.

11. Anordnung (24) nach Anspruch 10, **dadurch gekennzeichnet, dass** die zwei der Press Pack-Strukturen (6) auf einer Achse (33) liegen, wobei das zwischen ihnen liegende Winkelstück (29) U-förmig ist, und dass die dritte Press Pack-Struktur (6) auf einer dazu parallelen Achse (34) liegt.

12. Anordnung (24) nach Anspruch 11, **dadurch gekennzeichnet, dass** das Zwischenwinkelstück (31) durch ein nicht elektrisch leitfähiges Hilfswinkelstück (32) an dem U-förmigen Winkelstück (29) abgestützt ist.
